(19) Europäisches Patentamt
European Patent Office
Office européen des brevets

(11) **EP 3 297 008 A1**

(12) **EUROPEAN PATENT APPLICATION**
published in accordance with Art. 153(4) EPC

(43) Date of publication:
**21.03.2018 Bulletin 2018/12**

(21) Application number: **16792590.8**

(22) Date of filing: **28.04.2016**

(51) Int Cl.:
**H01G 4/33** (2006.01)          **H01G 4/10** (2006.01)
**H01G 4/12** (2006.01)

(86) International application number:
**PCT/JP2016/063418**

(87) International publication number:
**WO 2016/181865 (17.11.2016 Gazette 2016/46)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **12.05.2015 JP 2015097538**

(71) Applicant: **Murata Manufacturing Co., Ltd.**
**Nagaokakyo-shi, Kyoto 617-8555 (JP)**

(72) Inventors:
• **KANRYO, Koichi**
 **Nagaokakyo-shi**
 **Kyoto 617-8555 (JP)**
• **INOUE, Noriyuki**
 **Nagaokakyo-shi**
 **Kyoto 617-8555 (JP)**

• **SAEKI, Hiromasa**
 **Nagaokakyo-shi**
 **Kyoto 617-8555 (JP)**
• **ARAKAWA, Takeo**
 **Nagaokakyo-shi**
 **Kyoto 617-8555 (JP)**
• **HATTORI, Kazuo**
 **Nagaokakyo-shi**
 **Kyoto 617-8555 (JP)**
• **ITO, Ken**
 **Nagaokakyo-shi**
 **Kyoto 617-8555 (JP)**

(74) Representative: **Zinnecker, Armin**
 **Lorenz Seidler Gossel**
 **Rechtsanwälte Patentanwälte**
 **Partnerschaft mbB**
 **Widenmayerstraße 23**
 **80538 München (DE)**

(54) **CAPACITOR AND METHOD FOR MANUFACTURING SAME**

(57) The present invention provides a capacitor including a conductive metal base material with a porous part, a dielectric layer located on the porous part, and an upper electrode located on the dielectric layer, and has an electrostatic capacitance formation part only on one principal surface side.

FIG. 1

**EP 3 297 008 A1**

**Description**

TECHNICAL FIELD

This invention relates to a capacitor, and a method for manufacturing the capacitor.

BACKGROUND ART

In recent years, with higher-density mounting of electronic devices, capacitors with higher electrostatic capacitance have been required. As such a capacitor, for example, Patent Document 1 discloses therein a laminate-type solid electrolytic capacitor with a single-plate capacitor element laminated, where the single-plate capacitor element has a dielectric oxide film layer on the surface of an anode base composed of a valve-action metal, and has a solid electrolyte layer formed on the dielectric oxide film layer, and a conductor layer further formed thereon. In addition, as a method for manufacturing a capacitor, Patent Document 2 discloses therein a method for manufacturing a solid electrolytic capacitor, where a porous anode body composed of a valve-action metal is provided sequentially at a predetermined interval into the form of a hoop, a dielectric oxide film layer is formed on the surface of the anode body, a solid electrolyte layer is subsequently formed on the dielectric oxide film layer, and a cathode layer composed of carbon and a silver paint is then formed on the solid electrolyte layer, thereby preparing a capacitor element.

PRIOR ART DOCUMENTS

PATENT DOCUMENTS

    Patent Document 1: Japanese Patent Application Laid-Open No. 2010-28139
    Patent Document 2: Japanese Patent Application Laid-Open No. 2002-15957

SUMMARY OF THE INVENTION

Problem to be solved by the invention

The capacitor in Patent Document 1 is configured such that the dielectric oxide film layer, the solid electrolyte layer, and the electrode layer are formed to cover the circumference of the anode substrate, and there is a need to form the above-mentioned layers on, among two principal surfaces and four side surfaces of the anode substrate, the five surfaces excluding one side surface, thus making the manufacturing method difficult.
Likewise, the method for manufacturing a capacitor in Patent Document 2 also has a need to form the dielectric layer and the electrode layer on five surfaces of the plate as an anode body, and has a need to process the body as a structure of bodies connected in a comb-like form in order to expose the five surfaces without exposing the other surface. In this case, the comb-like form is difficult to handle, as compared with flat plates, and requires a bar for comb teeth (a part that connects comb teeth), thereby reducing the number of capacitors obtained therefrom.
An object of the present invention is to provide a capacitor which is easy to manufacture, and adapted to allow for an increased number of capacitors obtained per unit area of substrate, and a method for manufacturing the capacitor.

Means for solving the problem

The inventors have found, as a result of earnestly carrying out studies in order to solve the problems mentioned above, that for a capacitor, an electrostatic capacitance formation part is formed, for example, a dielectric layer is formed only on one principal surface of a conductive metal base material, thereby making it possible to manufacture the capacitor more easily and efficiently.
According to a first aspect of the present invention, a capacitor is provided, which includes:

    a conductive metal base material with a porous part;
    a dielectric layer located on the porous part; and
    an upper electrode located on the dielectric layer,
    where only one principal surface has an electrostatic capacitance formation part.

According to a second aspect of the present invention, a method for manufacturing a capacitor is provided, which includes:

> preparing a conductive substrate including a porous metal layer;
> at one principal surface of the conductive substrate,
> forming a groove that divides the porous metal layer, thereby forming a plurality of porous parts;
> forming a dielectric layer to cover the porous parts; and
> forming an upper electrode on the dielectric layer.

Advantageous effect of the invention

According to the present invention, there is no need to form any dielectric layer, electrode, or the like on side surfaces of the capacitor, or no need to expose any side surface of the base material during manufacture. Thus, there is no need to provide any comb-like base material as is conventionally, thereby resulting in ease of manufacture, and in an increased number of elements obtained per unit area of base material.

BRIEF EXPLANATION OF DRAWINGS

FIG. 1(a) is a schematic cross-sectional view of a capacitor 1 according to one embodiment of the present invention, and FIG. 1(b) is a schematic plan view of a conductive metal substrate of the capacitor 1.
FIG. 2(a) is an enlarged view of a high-porosity part of the capacitor in FIG. 1, and FIG. 2(b) is a diagram schematically illustrating a layered structure on the high-porosity part.
FIG. 3 is a diagram for explaining a method for manufacturing the capacitor 1 shown in FIG. 1. FIG. 3(a) is a schematic perspective view of a collective substrate, and FIG. 3(b) is a schematic cross-sectional view along the line x-x.
FIG. 4 is a diagram for explaining a step following FIG. 3. FIG. 4(a) is a schematic perspective view of the collective substrate, and FIG. 4(b) is a schematic cross-sectional view along the line x-x.
FIG. 5 is a diagram for explaining a step following FIG. 4. FIG. 5(a) is a schematic perspective view of the collective substrate, and FIG. 5(b) is a schematic cross-sectional view along the line x-x.
FIG. 6 is a diagram for explaining a step following FIG. 5. FIG. 6(a) is a schematic perspective view of the collective substrate, and FIG. 6(b) is a schematic cross-sectional view along the line x-x.
FIG. 7 is a diagram for explaining a step following FIG. 6. FIG. 7(a) is a schematic perspective view of the collective substrate, and FIG. 7(b) is a schematic cross-sectional view along the line x-x.
FIG. 8 is a diagram for explaining a step following FIG. 7. FIG. 8(a) is a schematic perspective view of the collective substrate, and FIG. 8(b) is a schematic cross-sectional view along the line x-x.
FIG. 9 is a schematic cross-sectional view of a capacitor according to Example 1.
FIG. 10 is a schematic cross-sectional view of a capacitor according to Example 3.
FIG. 11 is a schematic cross-sectional view of a capacitor according to Example 4.

MODE FOR CARRYING OUT THE INVENTION

A capacitor according to the present invention will be described in detail below with reference to the drawings. However, the capacitor according to the present embodiment, and the shapes and arrangement of respective constructional elements are not limited to the examples shown in the figures.

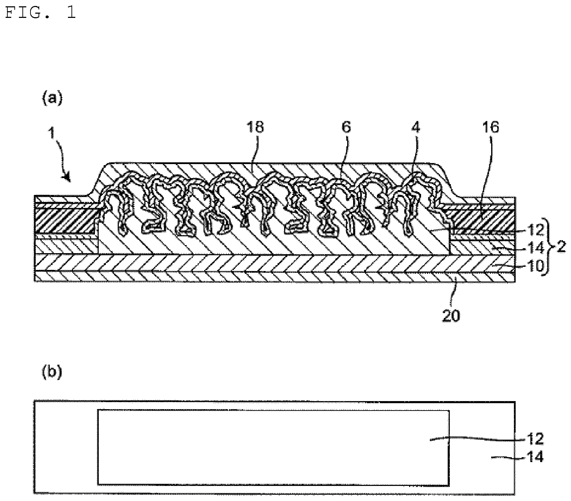

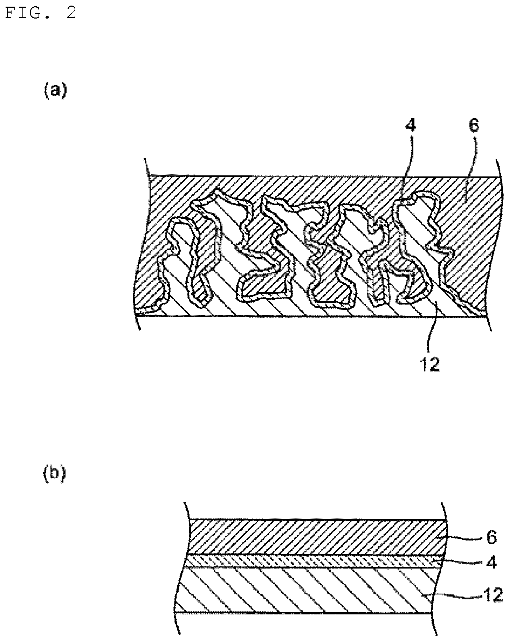

FIG. 1(a) shows a schematic cross-sectional view of a capacitor 1 according to the present embodiment, and FIG. 1(b) shows a schematic plan view of a conductive metal base material 2. In addition, FIG. 2(a) shows a schematic enlarged cross-sectional view of a high-porosity part 12 of the conductive metal base material 2, and FIG. 2(b) schematically shows a layered structure of the high-porosity part 12, a dielectric layer 4, and an upper layer 6.

As shown in FIGS. 1(a), 1(b), 2(a), and 2(b), the capacitor 1 according to the present embodiment has a substantially cuboid shape, and schematically has the conductive metal base material 2, the dielectric layer 4 formed on the conductive metal base material 2, and the upper electrode 6 formed on the dielectric layer 4. The conductive metal base material 2 has, on one principal surface side, the high-porosity part 12 which is relatively high in porosity, and a low-porosity part 14 which is relatively low in porosity. The high-porosity part 12 is located in the central part of a first surface of the conductive metal base material 2, and the low-porosity part 14 is located around the high-porosity part 12. More specifically, the low-porosity part 14 surrounds the high-porosity part 12. The high-porosity part 12 has a porous structure, namely corresponds to a porous part according to the present invention. In addition, the conductive metal base material 2 has a supporting part 10 on the other principal surface side. More specifically, the high-porosity part 12 and the low-porosity part 14 constitute the first surface of the conductive metal base material 2, whereas the supporting part 10 constitutes a second surface of the conductive metal base material 2. The first surface refers to the one principal surface as mentioned above, whereas the second surface refers to the other principal surface. The second surface refers to the surface on the side opposite to the first surface. In FIG. 1(a), the first surface refers to an upper surface of the conductive metal base material 2, whereas the second surface refers to a lower surface of the conductive metal base material 2. The capacitor 1 has, at ends thereof, an insulating part 16 present between the dielectric layer 4 and the upper electrode 6. The capacitor 1 includes a first external electrode 18 on the upper electrode 6, and a second external electrode 20 on the principal surface of the conductive metal base material 2 at the supporting part 10 thereof. In the capacitor 1 according to the present embodiment, the first external electrode 18 is electrically connected to the upper electrode 6, whereas the second external electrode 20 is electrically connected to the conductive metal base material 2. The upper electrode 6 and the high-porosity part 12 of the conductive metal base material 2 are opposed to each other with the dielectric layer 4 interposed therebetween to form an electrostatic capacitance formation part, and when a current is applied to the upper electrode 6 and the conductive base material 2, charges can be accumulated in the dielectric layer 4.

The material constituting the conductive metal base material 2 mentioned above is not particularly limited as long as the material is metallic, but examples of the metal include, for example, aluminum, tantalum, nickel, copper, titanium, niobium, and iron, and alloys such as stainless steel and duralumin. Preferably, the material constituting the conductive metal base material 2 is aluminum.

The conductive metal base material 2 mentioned above has the high-porosity part 12 and the low-porosity part 14 on the one principal surface side, and the supporting part 10 on the other principal surface side.

In this specification, the term "porosity" refers to the proportion of voids in the conductive metal base material. The porosity can be measured in the following way. It is to be noted that while voids in the porous part can be finally filled with the dielectric layer and the upper electrode, and the like in the process of preparing the capacitor, the "porosity" mentioned above is calculated with the filled sites also regarded as voids, without considering the thus filling substances.

First, the porous metal base material is processed by focused ion beam (FIB: Focused Ion Beam) processing into a thin section of 60 nm or less in thickness. A predetermined region (3 $\mu$m $\times$ 3 $\mu$m) of this thin section sample is photographed with the use of a transmission electron microscope (TEM: Transmission Electron Microscope). The obtained image is subjected to image analysis, thereby finding the area where a metal of the porous metal base material is present. Then, the porosity can be calculated from the following equality.

$$\text{Porosity} = ((\text{Measured Area} - \text{Area where Metal of Base Material is Present})/\text{Measured Area}) \times 100$$

In this specification, the term "high-porosity part" refers to a part that is higher in porosity than the supporting part and the low-porosity part of the conductive metal base material.

The high-porosity part 12 mentioned above has a porous structure. The high-porosity part 12 that has a porous structure increases the specific surface area of the conductive metal base material, thereby further increasing the electrostatic capacitance of the capacitor.

The porosity of the high-porosity part can be preferably 20% or more, more preferably 30% or more, further preferably 35% or more, from the perspective of increasing the specific surface area, thereby further increasing the electrostatic capacitance of the capacitor. In addition, from the perspective of ensuring the mechanical strength, the porosity is preferably 90% or less, more preferably 80% or less.

The high-porosity part is not particularly limited, but preferably has an expanded surface ratio of 30 times or more and 10,000 times or less, more preferably 50 times or more to 5,000 times or less, for example, 300 times or more and 600 times or less. In this regard, the expanded surface ratio refers to the surface area per unit projected area. The surface area per unit projected area can be obtained from the amount of nitrogen adsorption at a liquid nitrogen temperature with the use of a BET specific surface area measurement system.

In this specification, the term "low-porosity part" refers to a part that is low in porosity as compared with the high-porosity part. Preferably, the porosity of the low-porosity part is lower than the porosity of the high-porosity part, and equal to or more than the porosity of the supporting part.

The porosity of the low-porosity part is preferably 20% or less, more preferably 10% or less. In addition, the low-porosity part may have a porosity of 0%. More specifically, the low-porosity part may have a porous structure, or no porous structure. As the porosity of the low-porosity part is lower, the mechanical strength of the capacitor is improved.

It is to be noted that the low-porosity part is not an essential constructional element in the present invention, and there may be no low-porosity part. For example, in FIG. 1(a), the supporting part 10 may be exposed above without the low-porosity part 14.

According to the present embodiment, the conductive metal base material has one principal surface composed of the high-porosity part and the low-porosity part present around the high-porosity part, but the present invention is not limited thereto. More specifically, the locations, disposition numbers, sizes, shapes of high-porosity parts and low-porosity parts, the ratio between the both parts, and the like are not particularly limited. For example, the conductive metal base material may have one principal surface composed of only a high-porosity part. In addition, the high-porosity part may be present for the both principal surfaces of the conductive metal base material. In addition, the electrostatic capacitance of the capacitor can be controlled by adjusting the ratio between the high-porosity part and the low-porosity part.

The thickness of the high-porosity part 12 mentioned above is not particularly limited, but can be selected appropriately for any purpose, and may be, for example, 10 $\mu$m or more and 1000 $\mu$m or less, preferably 30 $\mu$m or more, and 300 $\mu$m or less, preferably 150 $\mu$m or less, more preferably 80 $\mu$m or less, and further preferably 40 $\mu$m or less.

The porosity of the supporting part of the conductive metal base material is preferably smaller in order to fulfill the function as a support, specifically preferably 10% or less, and more preferably, there is substantially no void.

The thickness of the supporting part 10 is not particularly limited, but in order to increase the mechanical strength of the capacitor, preferably 10 $\mu$m or more, and can be, for example, 100 $\mu$m or more or 500 $\mu$m or more. In addition, from the perspective of achieving a lower-profile capacitor, the thickness is preferably 1000 $\mu$m or less, and can be, for example, 500 $\mu$m or less, preferably 100 $\mu$m or less, more preferably 50 $\mu$m or less, further preferably 30 $\mu$m or less.

The thickness of the conductive metal base material 2 is not particularly limited, but can be selected appropriately for any purpose, and is, for example, 200 $\mu$m or less, preferably 80 $\mu$m or less, and further preferably 40 $\mu$m or less, and the lower limit is preferably 30 $\mu$m or more.

The method for manufacturing the conductive metal base material 2 is not particularly limited. For example, the conductive metal base material 2 can be manufactured by processing an appropriate metal material in accordance with a method for forming a porous structure, a method for filling a porous structure, or a method for removing a porous structure part, or a combined method thereof.

The metal material for the manufacture of the conductive metal base material can be a porous metal material (for example, etched foil) or a metal material that has no porous structure (for example metal foil), or a combined material thereof. The method for the combination is not particularly limited, but examples thereof include, for example, a method of bonding the materials by welding or with an electrically conductive adhesive material or the like.

Methods for forming the porous structure include, but not limited thereto, for example, an etching process.

Methods for filling the porous structure include, but not limited thereto, for example, a method of filling pores by melting a metal through laser irradiation or the like, or a method of filling pores by compression through die machining or press working. The laser mentioned above is not particularly limited, but a $CO_2$ layer, a YAG laser, an excimer laser, and all-solid-state pulsed lasers such as a femtosecond laser, a picosecond laser, and a nanosecond laser. All-solid-state pulsed lasers such as a femtosecond laser, a picosecond laser, and a nanosecond laser are preferred, because the shape and the porosity can be controlled with more precision.

Methods for removing the porous structure part include, but not limited thereto, for example, processing with a dicer and laser ablation processing. Lasers preferred for the laser abrasion include all-solid-state pulsed lasers such as a femtosecond laser, a picosecond laser, and a nanosecond laser. The use of these lasers can control the shape and the porosity with more precision.

In accordance with a method, the conductive metal base material 2 can be manufactured by preparing a porous metal material, and filling pores at sites of the porous metal base material, which correspond to the supporting part 10 and low-porosity part 14.

It is not necessary to form the supporting part 10 and the low-porosity part 14 simultaneously, but the parts may be formed separately. For example, first, the site of the porous metal base material, which corresponds to the supporting part 10, may be processed to form the supporting part 10, and then, the site thereof corresponding to the low-porosity part 14 may be processed to form the low-porosity part 14.

In accordance with another method, the conductive metal base material 2 can be manufactured by forming a porous structure, through processing a site of a metal base material (for example, metal foil) without any porous structure, which corresponds to a high-porosity part.

In accordance with yet another method, the conductive metal base material 2 without the low-porosity part 14 can be manufactured by filling pores at a site of a porous metal material, which corresponds to the supporting part 10, and then removing a site thereof corresponding to the low-porosity part 14.

In the capacitor 1 according to the present embodiment, the dielectric layer 4 is formed on the high-porosity part 12 and the low-porosity part 14.

The material that forms the dielectric layer 4 mentioned above is not particularly limited as long as the material has an insulating property, but examples thereof preferably include metal oxides such as $AlO_x$ (e.g., $Al_2O_3$), SiOx (e.g., $SiO_2$), $AlTiO_x$, SiTiOx, HfOx, TaOx, ZrOx, HfSiOx, $ZrSiO_x$, $TiZrO_x$, $TiZrWO_x$, $TiO_x$, $SrTiO_x$, $PbTiO_x$, $BaTiO_x$, $BaSrTiO_x$, $BaCaTiO_x$, and $SiAlO_x$; metal nitrides such as $AlN_x$, $SiN_x$, and $AlScN_x$; or metal oxynitrides such as $AlO_xN_y$, $SiO_xN_y$, $HfSiO_xN_y$, and $SiC_xO_yN_z$, and $AlO_x$, $SiO_x$, $SiO_xN_y$, and $HfSiO_x$ are preferred. It is to be noted that the formulas mentioned above are merely intended to represent the constitutions of the materials, but not intended to limit the compositions.

More specifically, the x, y, and z attached to O and N may have any value larger than 0, and the respective elements including the metal elements may have any presence proportion.

The thickness of the dielectric layer is not particularly limited, but for example, preferably 5 nm or more and 100 nm or less, more preferably 10 nm or more and 50 nm or less. The dielectric layer of 5 nm or more in thickness can increase the insulating property, and thus allows leakage current to be reduced. In addition, the dielectric layer of 100 nm or less in thickness makes it possible to achieve higher electrostatic capacitance.

The dielectric layer mentioned above is preferably formed by a gas-phase method, for example, a vacuum vapor deposition method, a chemical vapor deposition (CVD: Chemical Vapor Deposition) method, a sputtering method, an atomic layer deposition (ALD: Atomic Layer Deposition) method, a pulsed laser deposition method (PLD: Pulsed Laser Deposition), or the like. The ALD method is more preferred, because the ALD method can form a more homogeneous and denser film even in microscopic regions of pores of porous members.

In the capacitor 1 according to the present embodiment, the insulating part 16 is provided on ends of the dielectric layer 4. The insulating part 16 is disposed, thereby making it possible to prevent short circuits between the upper electrode 6 disposed thereon and the conductive metal base material 2.

It is to be noted that the insulating part 16 is, but not limited thereto, present entirely over the low-porosity part 14 according to the present embodiment, and may be present only partially over the low-porosity part 14, or present over the low-porosity part and even over the high-porosity part.

In addition, according to the present embodiment, the insulating part 16 is located between the dielectric layer 4 and the upper electrode 6, but the present invention is not limited thereto. The insulating part 16 has only to be located between the conductive metal base material 2 and the upper electrode 6, and may be located, for example, between the low-porosity part 14 and the dielectric layer 4, or between the supporting part 10 and the dielectric layer 4 when there is no low-porosity part 14.

The material that forms the insulating part 16 is not particularly limited as long as the material has an insulating property, but preferably a heat-resistant resin in the case of subsequently using an atomic layer deposition method. Various types of glass materials, ceramic materials, polyimide materials, and fluorine resins are preferred as an insulating material that forms the insulating part 16.

The thickness of the insulating part 16 is not particularly limited, but from the perspective of preventing end surface discharge in a more reliable manner, preferably 1 $\mu$m or more, more preferably, for example, 3 $\mu$m or more or 5 $\mu$m or more. In addition, from the perspective of achieving a lower-profile capacitor, the thickness is preferably 100 $\mu$m or less, and can be, for example, 50 $\mu$m or less, preferably 20 $\mu$m or less, more preferably 10 $\mu$m or less. It is to be noted that the thickness of the insulator part refers to the thickness at an end of the capacitor.

The width of the insulating part 16 is not particularly limited, but for example, from the perspective of suppressing crack generation at the electrostatic capacitance formation part or the insulating part in the manufacturing process, can be preferably 3 $\mu$m or more, more preferably 5 $\mu$m or more, further preferably 10 $\mu$m or more. In addition, from the perspective of further increasing the electrostatic capacitance, the insulating part 16 can be preferably 100 $\mu$m or less, more preferably 50 $\mu$m or less in width. It is to be noted that the width of the insulator part refers to a width from a capacitor end in a direction toward the center of the capacitor, for example, the maximum distance from a capacitor end to a point of contact with the dielectric layer 4 in the cross-sectional view in FIG. 1.

It is to be noted that in the capacitor according to the present invention, the insulating part 16 is not an essential element, and there may be no insulating part.

In the capacitor 1 according to the present embodiment, the upper electrode 6 is formed on the dielectric layer 4 and the insulating part 16.

The material constituting the upper electrode 6 mentioned above is not particularly limited as long as the material has a conductive property, but examples of the material include Ni, Cu, Al, W, Ti, Ag, Au, Pt, Zn, Sn, Pb, Fe, Cr, Mo, Ru, Pd, and Ta and alloys thereof, e.g., CuNi, AuNi, AuSn, metal oxides and metal oxynitrides such as TiN, TiAlN, TiON, TiAlON, TaN, and electrically conductive polymers (for example, PEDOT (poly(3,4-ethylenedioxythiophene)), polypyrrole, polyaniline), and TiN and TiON are preferred.

The thickness of the upper electrode is not particularly limited, but for example, preferably 3 nm or more, more preferably 10 nm or more. The upper electrode of 3 nm or more in thickness can reduce the resistance of the upper electrode itself.

The upper electrode may be formed by an ALD method. The use of the ALD method can further increase the electrostatic capacitance of the capacitor. The upper electrode may be formed by, as another method, a method such as a chemical vapor deposition (CVD: Chemical Vapor Deposition) method, plating, bias sputtering, a Sol-Gel method, or electrically conductive polymer filling, which can coat the dielectric layer, and substantially fill pores of the porous metal base material. Preferably, a conductive film may be formed by the ALD method on the dielectric layer, and pores may be filled thereon by other approach, with a conductive substance, preferably a substance that is lower in electrical resistance, thereby forming the upper electrode. This constitution can efficiently achieve a higher electrostatic capacitance density and a low equivalent series resistance (ESR: Equivalent Series Resistance).

It is to be noted that when the upper electrode fails to have sufficient conductivity as a capacitor electrode after the formation of the upper electrode, an extended electrode layer of Al, Cu, Ni, or the like may be additionally formed on the surface of the upper electrode by a method such as a sputtering method, vapor deposition, or plating.

According to the present embodiment, the first external electrode 18 is formed on the upper electrode 6.

According to the present embodiment, the second external electrode 20 is formed on the principal surface of the conductive metal base material 2 at the supporting part 10 thereof.

The materials constituting the first and second external electrodes 18, 20 are not particularly limited, but examples of the materials include, for example, metals such as Au, Pb, Ag, Sn, Ni, and Ci, and alloys thereof, and electrically conductive polymers.

In consideration of adhesion, solderability, solder leaching, electrical conductivity, wire bondability, laser resistance, and the like, the materials constituting the first and second external electrodes 18, 20 are preferably Cu, Ti/Al, Ni/Au, Ti/Cu, Cu/Ni/Au, Ni/Sn, or Cu/Ni/Sn (in this regard, for example, the Ti/Al indicates that an Al film is formed on a Ti film formed) when the material constituting the conductive metal base material 2 is aluminum. When the material constituting the conductive metal base material 2 is copper, the materials constituting the first and second external electrodes 18, 20 are preferably Al, Ti/Al, or Ni/Cu. Alternatively, when the material constituting the conductive metal base material 2 is nickel, the materials constituting the first and second external electrodes 18, 20 are preferably Al, Ti/Al, Cu, Au, or Sn.

The method for forming the external electrodes is not particularly limited, but for example, a CVD method, electrolytic plating, electroless plating, vapor deposition, a sputtering method, conductive paste baking, and the like can be used, and electrolytic plating, electroless plating, vapor deposition, a sputtering method, and the like are preferred.

It is to be noted that the first external electrode 18 and second external electrode 20 mentioned above are disposed entirely on the upper surface and lower surface of the capacitor, but not limited to the disposition, and can be disposed only partially on the respective surfaces in any shape and size. In addition, the first external electrode 18 and second external electrode 20 mentioned above are not essential elements, and there may be no external electrode. In this case, the upper electrode 6 also functions as a first external electrode, whereas the supporting part 10 also functions as a second external electrode. More specifically, the upper electrode 6 and the supporting part 10 may function as a pair of electrodes. In this case, the upper electrode 6 may function as an anode, whereas the supporting part 10 may function as a cathode. Alternatively, the upper electrode 6 may function as a cathode, whereas the supporting part 10 may function as an anode.

According to the present embodiment, the thickness of an end part (preferably, a peripheral part) of the capacitor is equal to or smaller than the thickness of the central part, preferably equal thereto. The end part can vary significantly in thickness, because the end part has a large number of layers laminated, and also readily changes in thickness due to the generation of burr and the like by cutting. Accordingly, the reduced thickness of the end part can reduce the influence on the external size (in particular, thickness) of the capacitor.

The capacitor according to the present invention is advantageous for the achievement of a lower-profile capacitor, and the thickness of the capacitor is not particularly limited, but can be made, for example, 100 μm or less, preferably 50 μm or less.

According to the present embodiment, the capacitor has a substantially cuboid shape, but the present invention is not limited to the shape. The capacitor according to the present invention can be made into any shape, and for example, the planar shape may be a circular shape, an elliptical shape, a quadrangular shape with round corners, and the like.

While the capacitor 1 according to the present embodiment has been described above, various modifications can be made to the capacitor according to the present invention.

For example, the capacitor may have, between the respective layers, a layer for enhancing the adhesion between the layers, or a buffer layer for preventing the diffusion of constituents between the respective layers. In addition, the capacitor may have, on a side surface or the like thereof, a protective layer.

In addition, according to the embodiment mentioned above, the conductive metal base material 2, the dielectric layer 4, the insulating part 16, and the upper electrode 6 are disposed in this order for the ends of the capacitor, but the present invention is not limited to this order. For example, the order of disposition is not particularly limited as long as the insulating part 16 is located between the upper electrode 6 and the conductive metal base material 2, but for example, the conductive metal base material 2, the insulating part 16, the dielectric layer 4, and the upper electrode 6 may be disposed in this order. The conductive metal base material 2 at ends of the capacitor may be any of the high-porosity part 12, the low-porosity part 14, and the supporting part 10, or may be a combination thereof. For example, at ends of the capacitor, the supporting part 10, the low-porosity part 14, the insulating part 16, the dielectric layer 4, and the upper electrode 6 may be disposed in this order,

the supporting part 10, the low-porosity part 14, the dielectric layer 4, the insulating part 16, and the upper electrode 6 may be disposed in this order,

the supporting part 10, the insulating part 16, the dielectric layer 4, and the upper electrode 6 may be disposed in this order, or

the supporting part 10, the dielectric layer 4, the insulating part 16, and the upper electrode 6 may be disposed in this order.

Furthermore, the capacitor 1 according to the embodiment mentioned above has the upper electrode and the external electrodes to reach even edges of the capacitor, but the present invention is not limited thereto. According to an embodiment, the upper electrode (preferably, the upper electrode and the first external electrode) are disposed away from edges of the capacitor. This disposition can prevent end surface discharge. More specifically, the upper electrode may not be formed to cover all of the porous part, and the upper electrode may be formed to cover only the high-porosity part.

The capacitor according to the present invention has a simple configuration, and it is thus easy to manufacture the capacitor. In particular, there is no need for processing in such a conventional way that five surfaces of the base material are disposed, whereas one surface thereof is not exposed. Therefore, the manufacturability as a pseudo collective substrate without the need for any comb-like substrate thus results in ease of handling during manufacture, and in an increased number of capacitors obtained per unit area of substrate. In addition, for the capacitor according to the present invention, the essential elements are only the conductive metal base material including a porous part only at one principal surface, the dielectric layer located on the porous part, and the upper electrode located on the dielectric layer, and the number of layers laminated can be thus reduced, thereby easily achieving a lower-profile and smaller-size capacitor. Furthermore, for the capacitor according to the present invention, the external electrodes can be formed on the principal surfaces of the capacitor and the electrode area can be thus increased.

In addition, the capacitor is also advantageous in that the resistance can be reduced because the electrical conduction paths to the external electrodes and the dielectric layers are small in length.

The capacitor according to the present invention can be used as a built-in component for a circuit board in a preferred manner. The capacitor according to the present invention has the electrodes on the principal surfaces of the capacitor, thereby making it possible to ensure a large electrode area, and thus, when the capacitor is used as a built-in component for a circuit board, laser drilling for electrical connections is easily carried out.

The capacitor according to the present invention can be manufactured by a method including:

preparing a plate-like conductive substrate including a porous metal layer at one principal surface;
forming a groove that divides the porous metal layer, thereby forming a plurality of porous parts;
forming a dielectric layer to cover the porous parts; and
forming an upper electrode on the dielectric layer.

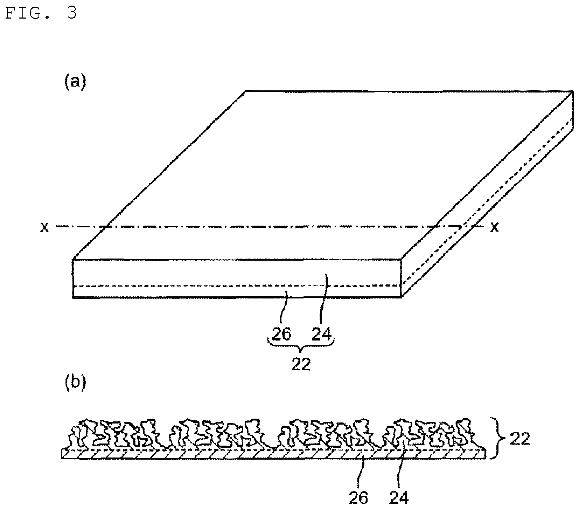

A process for manufacturing the capacitor 1 according to the embodiment mentioned above will be specifically described below with reference to the drawings. It is to be noted that as for FIGS. 3 to 8 respectively, FIGS. 3(a) to 8(a) each schematically show a perspective view of a collective substrate of capacitor bodies, whereas FIGS. 3(b) to 8(b) each schematically show a cross-sectional view of the collective substrate along the line x-x.

As shown in FIG. 3, first, a conductive substrate 22 is prepared. Examples of the material constituting the conductive substrate 22 include, for example, aluminum, tantalum, nickel, copper, titanium, niobium, and iron, and alloys such as stainless steel and duralumin. Preferably, the material constituting the conductive metal substrate 22 is aluminum. The conductive substrate 22 has a porous metal layer 24 on one principal surface side, and a support layer 26 on the other principal surface side. More specifically, one surface of the conductive substrate 22 is composed of the porous metal layer 24, whereas the surface of the conductive substrate 22 on the side opposite to the one surface is composed of the support layer 26. The porosity of the porous metal layer 24 is higher than the porosity of the support layer 26. In addition, the expanded surface ratio of the porous metal layer 24 is higher than the expanded surface ratio of the support layer 26. More specifically, the porous metal layer 24 is larger in specific surface area than the support layer 26.

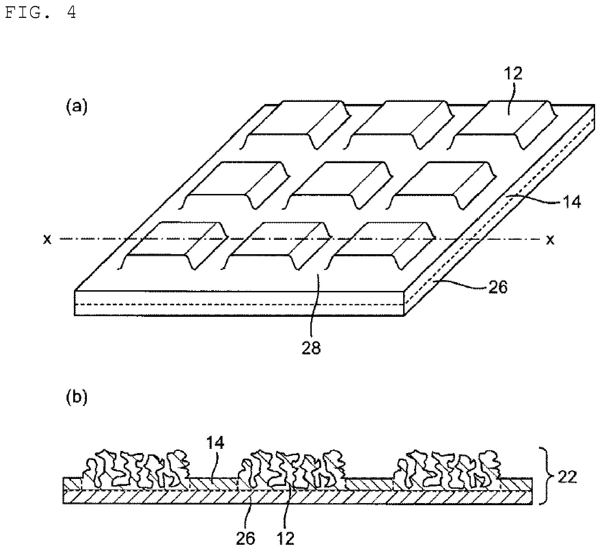

Next, as shown in FIG. 4, pores in a partial region of the porous metal layer 24 are filled to form a groove 28, and thus divide the porous metal layer. The divided porous metal layers correspond to high-porosity parts 12. The groove is formed between the high-porosity parts 12, and the bottom surface of the groove is composed of the low-porosity part 14 formed by filling the porous metal layer 24. Those listed above as methods for filling pores can be used for the method for forming the groove. More specifically, the method for forming the groove can be a method of filling pores by compression through die machining or press working, or a method of filling pores by melting a metal with a laser or the like. In addition, according to another embodiment, the methods of removal with a dicer, a laser, or the like can be used in the case of forming the groove through partial removal of the porous metal layer 24.

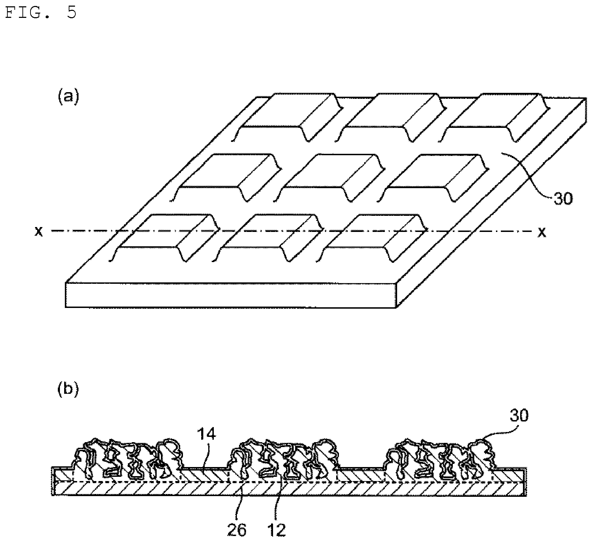

Next, as shown in FIG. 5, on the substrate obtained as mentioned above, a dielectric layer 30 is formed by a gas-phase method, preferably, an ALD method.

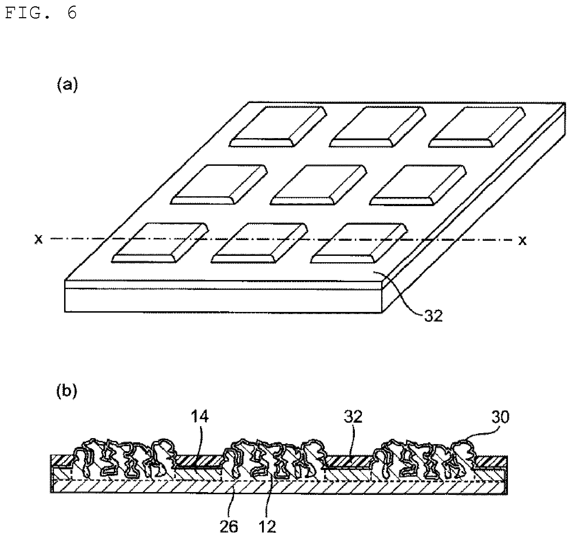

Next, as shown in FIG. 6, an insulating part 32 is formed on the groove 28. The method for forming the insulating part 32 can be implemented by filling the groove 28 with an insulating material (for example, a resin) or applying the insulating material to the bottom of the groove 28 with the use of an air-type dispenser, a jet dispenser, ink-jet, screen printing, an electrostatic application method, or the like. Filling the insulating material is preferably filling halfway the depth of the groove. This adjustment to the filling amount can, even in the case of varying in application amount, prevent the insulating material from spilling from the groove, and thus prevent the variation in thickness.

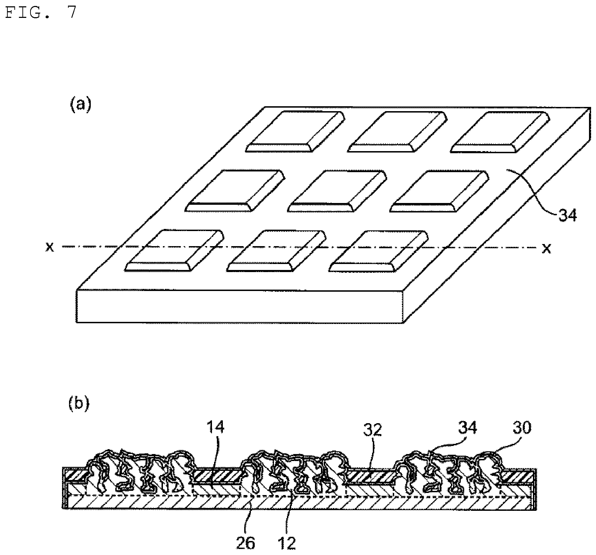

Next, as shown in FIG. 7, an upper electrode 34 is formed entirely over the substrate obtained as mentioned above. The upper electrode 34 can be formed by a method such as an ALD method, a CVD method, plating, bias sputtering, a Sol-Gel method, and electrically conductive polymer filling. In addition, these methods can be used in combination. For example, the upper electrode may be formed in a way that a conductive film is formed first by an ALD method, and pores are further filled thereon by another method.

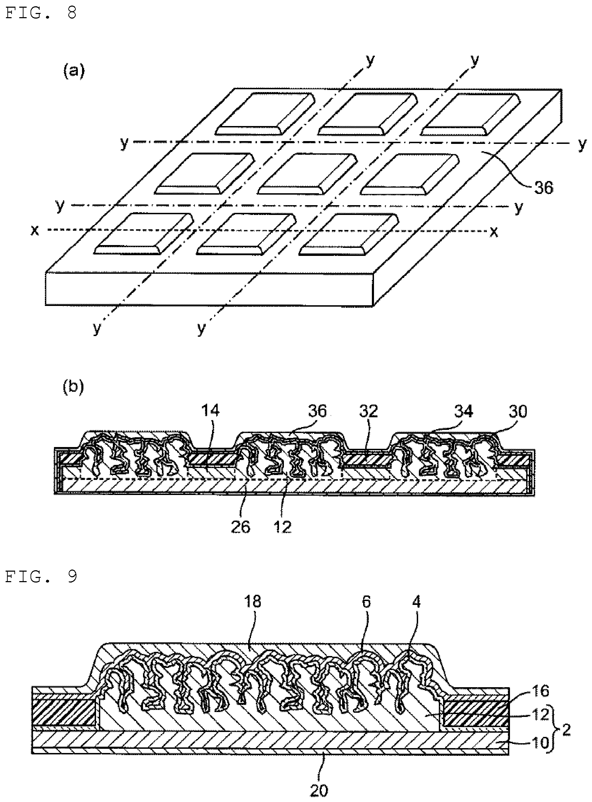

Next, as shown in FIG. 8, an external electrode 36 is formed entirely over the substrate obtained as mentioned above. Methods for forming the external electrode include, but not particularly limited thereto, for example, a sputtering method, vapor deposition, electrolytic plating, and electroless plating. While pores of the porous part are filled with the external electrode 36 in FIG. 8, some or all of the pores may remain as voids.

The capacitor according to the present invention can be obtained by cutting the substrate obtained as mentioned above along the lines y-y shown in FIG. 8. The method for cutting is not particularly limited, but, the material can be cut by a single one or combination of, for example, cutting with a laser, punching through a mold, and cutting with a dicer, a carbide blade, a slitter, or a pinnacle blade. Further, this cutting also divides the external electrode 36, thereby forming first external electrodes and second external electrodes.

It is to be noted that the insulating part and the external electrodes are optional elements for the capacitor according to the present invention, and thus, when there is no insulating part or external electrodes, the method for manufacturing the capacitor according to the present invention includes, of course, none of the steps of forming the insulating part and the external electrodes.

As is clear from FIGS. 3 to 8, in accordance with the method for manufacturing the capacitor according to the present invention, the capacitor can be manufactured by processing only one side of the conductive substrate, except for the formation of the second external electrode. Therefore, there is no need for the conductive substrate to be made into a comb-like form, but the form of a collective substrate can be adopted, thus resulting in ease of handling during manufacture, and in an increased number of capacitors obtained per unit area of substrate.

While the capacitor and manufacturing method therefor according to the present invention have been described above with reference to the capacitor 1 according to the embodiment as mentioned above, the present invention is not to be considered limited to the capacitor or manufacturing method, but various modifications can be made thereto.

EXAMPLES

(Example 1)

As a conductive substrate, commercially available aluminum etched foil for aluminum electrolytic capacitors, with a thickness of 80 μm and an expanded surface ratio of approximately 200 times, was prepared, with a porous metal layer of 60 μm in thickness formed only on one side of the foil (corresponding to FIG. 3). More specifically, according to the present example, the support layer and the porous metal layer are formed from aluminum. The aluminum etched foil mentioned above was processed with the use of a nanosecond pulsed fiber laser system, thereby partially removing the porous metal layer, and thus forming a groove (corresponding to FIG. 4: substantially no low-porosity part 14 due to removal with the laser).

Next, an AlOx film of 20 nm was formed by an atomic layer deposition method, thereby forming a dielectric layer (corresponding to FIG. 5). Then, the groove was filled with a polyimide resin with the use of an air-type dispenser system so as to leave the groove of 20 μm in depth, thereby forming an insulating part (40 μm in thickness) (corresponding to FIG. 6).

Then, a TiN film was formed as an upper electrode entirely over the substrate with the use of an atomic layer deposition method (corresponding to FIG. 7). Next, the lower surface (on the supporting part side) of the substrate obtained was subjected to a zincate treatment as a pretreatment for plating, and electroless Ni plating was then formed. Then, the entire substrate was plated with Cu by an electroless plating method, thereby forming first and second external electrodes (corresponding to FIG. 8).

The substrate obtained as a collective substrate with a plurality of capacitors, was cut at a central part of the groove (corresponding to the lines y-y in FIG. 8) with the use of a nanosecond pulsed fiber laser system, thereby providing individual capacitors as shown in FIG. 9. The size of the capacitor obtained was 97 μm in height dimension, and 0.7 mm in width dimension and length dimension.

(Example 2)

The capacitor shown in FIG. 1 was prepared in the same way as in Example 1, except that a groove was formed by compression with a die. The capacitor according to Example 2 has a low-porosity part present at a site corresponding to the groove, because of the groove formed by compressing the porous metal layer.

(Example 3)

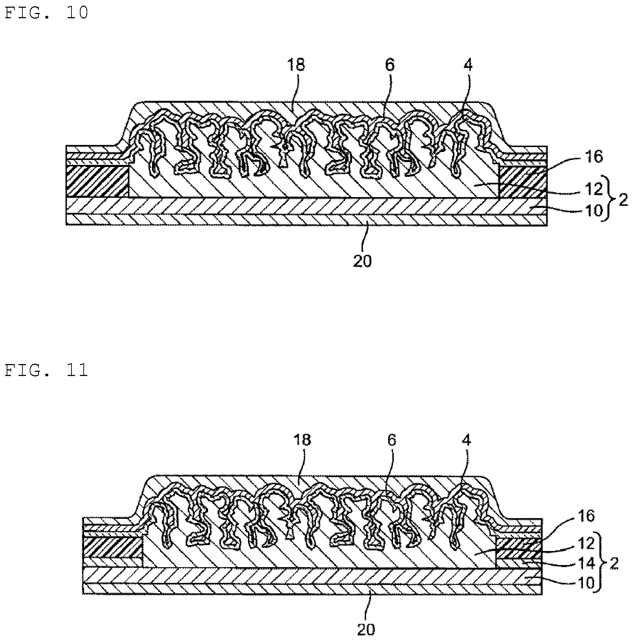

The capacitor shown in FIG. 10 was prepared in the same way as in Example 1, except for the formation of an insulating part, and then the formation of a dielectric layer. The capacitor according to Example 3 has a supporting part, the insulating part, the dielectric layer, and an upper electrode laminated in this order at ends of the capacitor.

(Example 4)

The capacitor shown in FIG. 11 was prepared in the same way as in Example 2, except for the formation of an insulating part, and then the formation of a dielectric layer. The capacitor according to Example 4 has a supporting part, a low-porosity part, the insulating part, the dielectric layer, and an upper electrode laminated in this order at ends of the capacitor.

(Examples 5 to 13)

As a conductive substrate, commercially available aluminum etched foil for aluminum electrolytic capacitors, with a thickness of 30 $\mu$m and an expanded surface ratio of approximately 200 times, was prepared, with a porous metal layer of 20 $\mu$m in thickness formed on one side of the foil. More specifically, according to the present example, the support layer and the porous metal layer are formed from aluminum. The aluminum etched foil mentioned above was subjected to an ablation treatment with the use of a nanosecond pulsed fiber laser system, thereby partially removing the porous metal layer, and thus forming a groove (in this regard, substantially no low-porosity part due to removal with the laser). The width of the groove formed (the width of an insulating part) was adjusted to be 3 $\mu$m, 5 $\mu$m, or 10 $\mu$m after division into individual capacitors, thereby providing three types of collective substrates.

Then, a polyimide resin was applied into the grooves of the various types of collective substrates with the use of an air-type dispenser system, thereby forming insulating layers. The resin was applied such that the insulating layers were 3 $\mu$m, 5 $\mu$m, or 10 $\mu$m in thickness, thereby providing three types of collective substrates for each of the three types of collective substrates mentioned above (9 types in total).

Next, an AlOx film of 20 nm was formed by an atomic layer deposition method, thereby forming a dielectric layer. Then, a TiN film was formed as an upper electrode entirely over the substrates with the use of an atomic layer deposition method.

Next, the lower surfaces (on the supporting part side) of the substrates obtained were subjected to a zincate treatment as a pretreatment for plating, and first and second external electrodes were then formed by an electroless plating method, in a way that a Ni film of 5 $\mu$m in film thickness was formed on the upper electrodes, and a Sn film of 3 $\mu$m in film thickness was further formed thereon.

The substrates obtained as collective substrates with a plurality of capacitors, were cut at a central part of the groove with the use of a nanosecond pulsed fiber laser system, thereby providing samples (capacitors) according to Examples 5 to 13, structured as shown in FIG. 10. The sizes of the capacitors obtained were 47 $\mu$m in height dimension, and 0.7 mm in width dimension and length dimension.

(Evaluation)

Porosity

Two samples were extracted randomly from samples according to each of Examples 5 to 13, obtained as mentioned above, and the porosity of the conductive metal base material was measured as follows.

First, a substantially central part of the high-porosity part of the conductive metal base material was processed into a thin section by a FIB pickup method with the use of a FIB (Focused Ion Beam) system (SMI 3050SE from Seiko Instruments Inc.), so as to be approximately 50 nm in thickness, thereby preparing a measurement sample. It is to be noted that a FIB damage layer produced in processing into the thin section was removed with the use of an Ar ion milling system (PIPS model 691 from GATAN).

Then, images were taken at five random points for each sample in an imaging area of 3 $\mu$m $\times$ 3 $\mu$m with the use of a scanning transmission electron microscope (JEM-2200FS from JEOL Ltd.). Then, these images taken were analyzed to obtain the areas (hereinafter, referred to as "existence areas") $a1$ of Al existence regions, and on the basis of the following formula (1), the individual porosities $x$ in regions of the high-porosity part were calculated from the existence areas $a1$ and the measurement area $a2$ (= 3 $\mu$m $\times$ 3 $\mu$m).

$$x = \{(a2 - a1)/a2\} \times 100 \quad \ldots (1)$$

Then, the average value for the individual porosities x at the five points was obtained, the average for the two samples was further obtained, and this average value was regarded as the porosity of the high-porosity part for each sample. The results are shown in Table 1.

• Non-Defective Ratio

For 100 samples for each of Examples 5 to 13, a direct-current voltage of DC 1V was applied across terminals of the capacitors, thereby confirming the presence or absence of any short circuit, and the samples without any short circuit caused were regarded as non-defective articles, thereby figuring out the non-defective ratio. The results are shown in Table 1.

• Dielectric Breakdown Voltage

For 5 samples for each of Examples 5 to 13, the direct-current voltages applied across the terminals of the capacitors were gradually increased, and the voltages in the case of currents flowing through the samples in excess of 1 mA, that is, the dielectric breakdown voltages were measured. The average for the five samples was obtained, and this average value was regarded as a dielectric breakdown voltage for each sample. The results are shown in Table 1.

[Table 1]

| Example Number | Dimension of Insulating Part | | Porosity (%) | Non-Defective Ratio (%) | Dielectric Breakdown Voltage (V) |
|---|---|---|---|---|---|
| | Width ($\mu$m) | Thickness ($\mu$m) | | | |
| 5 | 3 | 3 | 58 | 65 | 3.2 |
| 6 | 3 | 5 | 57 | 74 | 5.1 |
| 7 | 3 | 10 | 59 | 79 | 5.5 |
| 8 | 5 | 3 | 56 | 82 | 3.5 |
| 9 | 5 | 5 | 57 | 93 | 5.2 |
| 10 | 5 | 10 | 57 | 95 | 5.8 |
| 11 | 10 | 3 | 58 | 89 | 3.6 |
| 12 | 10 | 5 | 59 | 95 | 5.5 |
| 13 | 10 | 10 | 58 | 93 | 5.6 |

From the foregoing results, it has been confirmed that the formation of the insulating part between the conductive metal base material and the upper electrode can increase the non-defective ratio, and further enhance the insulating property between the conductive metal base material and the upper electrode. In addition, it has been confirmed that the non-defective ratio can be increased by adjusting the width dimension of the insulating part to 5 $\mu$m or more. Furthermore, the insulating property between the conductive metal base material and the upper electrode can be increased by adjusting the thickness dimension of the insulating part to 5 $\mu$m or more.

INDUSTRIAL APPLICABILITY

The capacitor according to the present invention is remarkably stable and highly reliable, and thus used for various electronic devices in a preferred manner. The capacitor according to the present invention, which is mounted onto a substrate, is used as an electronic component. Alternatively, the capacitor according to the present invention, which is embedded into a substrate or an interposer, is used as an electronic component.

DESCRIPTION OF REFERENCE SYMBOLS

1: capacitor
2: conductive metal base material
4: dielectric layer
6: upper electrode
10: supporting part
12: high-porosity part
14: low-porosity part
16: insulating part
18: first external electrode
20: second external electrode
22: conductive substrate
24: porous metal layer
26: supporting layer
28: groove
30: dielectric layer
32: insulating part
34: upper electrode
36: external electrode

**Claims**

1. A capacitor comprising:

   a conductive metal base material comprising a porous part;
   a dielectric layer located on the porous part; and
   an upper electrode located on the dielectric layer,
   wherein only one principal surface has an electrostatic capacitance formation part.

2. The capacitor according to claim 1, comprising:

   the conductive metal base material comprising the porous part at only one principal surface;
   the dielectric layer located on the porous part; and
   the upper electrode located on the dielectric layer.

3. The capacitor according to one of claims 1 and 2,
   wherein the dielectric layer is formed by an atomic layer deposition method.

4. The capacitor according to any one of claims 1 to 3,
   wherein the upper electrode is formed by an atomic layer deposition method.

5. The capacitor according to any one of claims 1 to 4,
   wherein the conductive metal base material comprises a low-porosity part that is lower in porosity than the porous part.

6. The capacitor according to any one of claims 1 to 5,
   wherein the upper electrode is kept away from an edge of the capacitor.

7. The capacitor according to any one of claims 1 to 6,
   wherein an insulating part is present in any location between the conductive metal base material and the upper electrode at an end of the capacitor.

8. The capacitor according to claim 7, wherein the conductive metal base material, the dielectric layer, the insulating part, and the upper electrode are disposed in this order at an end of the capacitor.

9. The capacitor according to claim 7, wherein the conductive metal base material, the insulating part, the dielectric layer, and the upper electrode are disposed in this order at an end of the capacitor.

10. A method for manufacturing a capacitor, the method comprising:

    preparing a conductive substrate comprising a porous metal layer; and
    at one principal surface of the conductive substrate,
    forming a groove that divides the porous metal layer, thereby forming a plurality of porous parts;
    forming a dielectric layer to cover the porous parts; and
    forming an upper electrode on the dielectric layer.

FIG. 1

(a)

(b)

FIG. 2

(a)

(b)

FIG. 3

(a)

X — · — · — · — · — · — · — · — · — · — X

26  24

22

(b)

22

26  24

FIG. 4

(a)

(b)

FIG. 5

(a)

30

X — · — · — · — · — · — · — · — · — · — · — X

(b)

30

14

26  12

FIG. 6

(a)

32

(b)

14    32    30

26  12

FIG. 7

(a)

34

X ———————————————————————————————— X

(b)

14         32    34    30

26   12

FIG. 8

(a)

(b)

FIG. 9

FIG. 10

FIG. 11

## INTERNATIONAL SEARCH REPORT

| International application No. |
| --- |
| PCT/JP2016/063418 |

**A. CLASSIFICATION OF SUBJECT MATTER**
*H01G4/33*(2006.01)i, *H01G4/10*(2006.01)i, *H01G4/12*(2006.01)i

According to International Patent Classification (IPC) or to both national classification and IPC

**B. FIELDS SEARCHED**

Minimum documentation searched (classification system followed by classification symbols)
H01G4/33, H01G4/10, H01G4/12

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2016 |
| Kokai Jitsuyo Shinan Koho | 1971-2016 | Toroku Jitsuyo Shinan Koho | 1994-2016 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X<br>Y | JP 2010-520647 A (Kemet Electronics Corp.),<br>10 June 2010 (10.06.2010),<br>claim 1; paragraph [0016]; fig. 1 to 7<br>& US 2008/0216296 A1<br>claim 1; paragraph [0050]; fig. 1 to 7<br>& WO 2008/109283 A1    & EP 2130208 A1<br>& CN 101627449 A | 1-2,6-8,10<br>3-5,9 |
| Y | JP 2012-043960 A (Panasonic Corp.),<br>01 March 2012 (01.03.2012),<br>paragraphs [0039], [0043]; fig. 3<br>(Family: none) | 3,5,9 |
| Y | JP 2009-081429 A (Tosoh Corp.),<br>16 April 2009 (16.04.2009),<br>paragraph [0014]<br>(Family: none) | 4 |

[X] Further documents are listed in the continuation of Box C.  [ ] See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered    to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>08 July 2016 (08.07.16) | Date of mailing of the international search report<br>19 July 2016 (19.07.16) |
| --- | --- |
| Name and mailing address of the ISA/<br>Japan Patent Office<br>3-4-3,Kasumigaseki,Chiyoda-ku,<br>Tokyo 100-8915,Japan | Authorized officer<br><br>Telephone No. |

Form PCT/ISA/210 (second sheet) (January 2015)

**EP 3 297 008 A1**

**INTERNATIONAL SEARCH REPORT**

International application No.

PCT/JP2016/063418

C (Continuation).   DOCUMENTS CONSIDERED TO BE RELEVANT

| Category* | Citation of document, with indication, where appropriate, of the relevant passages | Relevant to claim No. |
|---|---|---|
| A | WO 2012/144316 A1  (Murata Mfg. Co., Ltd.), 26 October 2012 (26.10.2012), entire text; all drawings & US 2014/0036417 A1 entire text; all drawings & WO 2012/144316 A1     & CN 103430261 A | 1-10 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010028139 A
- JP 2002015957 A